# EUROPEAN PATENT APPLICATION

(11) **EP 3 744 690 A1**
(43) Date of publication of application: **02.12.2020**
(21) Application number: 19177031.2
(22) Date of filing: 28.05.2019
(51) Int. Cl.: C02F 1/00, C02F 1/32, G01J 1/32, G01J 1/42

(54) **CONTROL CIRCUIT FOR CONTROLLING A UV LIGHT SOURCE**

(71) Applicant: Watersprint AB, 223 81 Lund (SE)
(72) Inventor: Lindqvist, Mathias, 227 31 Lund (SE); Kokkola, Linda, 223 52 Lund (SE)
(74) Representative: AWA Sweden AB

(57) **Abstract**

A control circuit for controlling a UV light source configured to emit UV light into a purifying chamber of a device for purifying a fluid, the control circuit comprising a driver configured to provide the UV light source with a drive current; a fluid flow sensor configured to determine whether a flow of a fluid through the purifying chamber is present and generate a flow signal indicative thereof; a light sensor configured to measure radiant flux of light emitted from the UV light source and to generate a radiant flux signal comprising data pertaining to the measured radiant flux; a memory comprising a reference radiant flux; and a processor configured to: deactivate the UV light source upon the flow signal being indicative of non-presence of flow of fluid through the purifying chamber, activate the UV light source upon the flow signal being indicative of presence of flow of fluid through the purifying chamber, during the UV light source being active: determine the drive current for the driver based on the measured radiant flux comprised in the radiant flux signal and the reference radiant flux.

## Description

### Field of the invention

The invention relates to the field of purifying fluid using UV light, in particular it related to a control circuit for controlling a UV light source configured to emit UV light into a chamber for purifying fluid.

### Background art

Decontamination by means of ultra violet (UV) light is a well-established and reliable technique for use in systems for purifying fluids, in particular systems suitable for providing potable water. These systems are efficient and perform satisfactory without the use of any chemicals. UV light in fluid purification systems has the purpose of destroying the metabolic activity, mainly the DNA of bacteria, or other microorganisms being present in the water. UV light can purify a fluid by destroying DNA/RNA of organisms present within the fluid. This prevents microorganisms from reproducing.

Typically, raw water is treated in a water supply plant whereafter this treated, refined water, frequently referred to as tap water, is made available to the end users via a water distribution system. In countries with rigorous water quality regulation, the term tap water is interchangeable with the term potable water. Elsewhere, tap water should undergo further treatment prior to being consumed. In both described cases, the tap water remains susceptible to contamination, in particular to biological infection. There have been examples when large communities and towns have had their water being infected even though their tap water on normal basis would be potable water.

When using UV light sources such as LEDs to purify fluids such as water, it is known that LEDs have a gradual degradation over time. LEDs are sensitive to high temperatures which affects the life span of the LEDs since they emit heat themselves.

Thus, there is room for improvements to LED systems to be used in systems for purifying fluid such as water.

### Summary of the invention

It is an object of the present inventive concept to at least reduce the above stated issues by providing an improved control circuit for controlling a UV light source for a device for purifying fluid.

According to a first aspect, there is provided a control circuit for controlling a UV light source configured to emit UV light into a purifying chamber of a device for purifying a fluid, the control circuit comprising: a driver configured to provide the UV light source with a drive current; a fluid flow sensor configured to determine whether a flow of a fluid through the purifying chamber is present and generate a flow signal indicative thereof; a light sensor configured to measure radiant flux of light emitted from the UV light source and to generate a radiant flux signal comprising data pertaining to the measured radiant flux; a memory comprising a reference radiant flux; and a processor configured to: deactivate the UV light source upon the flow signal is indicative of non-presence of flow of fluid through the purifying chamber, activate the UV light source upon the flow signal is indicative of presence of flow of fluid through the purifying chamber, during the UV light source being active: determine the drive current for the driver based on the measured radiant flux comprised in the radiant flux signal and the reference radiant flux.

The present control circuit provides control of a UV light system such that the UV light source has a prolonged life span. This is partly achieved by the UV light source being switched on and off on a continuous basis based on if there is a flow of fluid through the purifying chamber or not.

The present control circuit may improve the life span of the UV light source by determining whether or not a flow of fluid is present. When there is no flow of fluid, there is no need to use up the life of the UV light source, by letting the UV light source emit light.

By the processor determining the drive current for the UV light source, a more efficient use of power may be achieved. The dive current determines the output of the UV light source, and in other words, the processor determines how much UV light is emitted into the purifying chamber. This may be advantageous since the life span of the UV light source may be increased. This since the UV-light source does not need to run on full power all the time. Further, by the processor determining the drive current for the UV light source, improved purifying of the fluid may be achieved. The output of the UV light source decontaminates and purifies the fluid. If the UV light output is too low, the fluid will not be effectively purified. On the other hand, if the UV light output is too high, the life span of the UV light source will be reduced. Thus, by controlling the driver current, the UV light output can be controlled such as to provide effective purifying of the fluid present in the purifying chamber and at the same time increase the life span of the UV light source.

When the present circuit is placed within a device for purifying a fluid such as water, a more efficient water supply system may be achieved. In such a case, the present circuit may prolong the life span of the UV light source such that said device can purify water for a longer time. Thus, the UV light source may not need to be exchanged on a frequent basis. This may provide an efficient system for purifying water.

The present disclosure provides the advantage of the UV light source only being active when there is a flow of fluid to purify present in the purifying chamber. Thus, no UV light is emitted when there is no fluid to purify. An environmentally friendly system for purifying a fluid may be achieved. Moreover, the control circuit provides an environmentally friendly control of the UV light source, since UV light sources need a power source to function, and the power supply is efficiently controlled by the present control circuit.

The fluid flow sensor may be configured to measure a flow rate of a fluid flowing through the purifying chamber. The flow signal may comprise data pertaining to the measured flow rate. The processor may be configured to determine the drive current for the driver based on the measured flow rate comprised in the flow signal. By this, the processor may use the data pertaining to the flow rate in order to control the output of the UV light source. In other words, the processor may control how much light is emitted into the purifying chamber based on how much fluid is flowing through the purifying chamber. Thus, a more efficient use of the UV light source may be achieved. The processor may use the data pertaining to the flow rate to determine the amount of UV light to be emitted by the UV light source into the purifying chamber. This may improve the efficiency and power usage when purifying the fluid.

The light sensor may be configured to measure UV-C light radiant flux. The reference radiant flux may be a UV-C light reference radiant flux.

The UV light source may comprise one or more UV LEDs. The one or more UV LEDs may be Waverlevel Integrated Chip On PCB (WICOP) LEDs. The one or more UV LEDs may be UV-C LEDs. The UV-C LEDs may be packaged UV-C LEDs. The processor may use the data pertaining to the flow rate to determine how many UV LEDs to activate. This may improve the efficiency of the system when purifying fluid. UV-C LEDs have a limited life span, but an advantage of using UV-C LEDs is that they may not easily break from switching on and off on a frequent basis. An advantage of using WICOP LEDs is that they may not easily break form switching on and off on a frequent basis. WICOP LEDS may provide a flexible manufacturing of the UV light source since WICOP LEDS may be easily customized. This may provide a cost efficient UV light source. This may improve the live span of the UV light source. UV-C light may operate at a wavelength of 100 to 280 nano-meters, thus have germicidal properties. Because of this, it may be beneficial to use UV-C LEDs if water is the fluid to be purified. When the control circuit is added to a system for purifying a fluid, the purifying system will thereby have a longer life span. In turn, the ability to purify fluid may be improved due to the longer life span of the purifying device.

The control circuit may comprise a temperature sensor configured to measure a temperature of a UV LED and generate a temperature signal. The processor may be configured to upon the temperature signal being indicative of that the temperature of the LED is above a predetermined temperature threshold generate a LED overheat signal. By this, the control circuit may be able to prevent any overheating of the LED of the purifying device. This may provide a cost efficient device for purifying fluid. The processor may be configured to deactivate the LED based on the overheat signal. Thus, a failure of the UV light source may be avoided. By controlling the temperature of the LED, the life span of the UV light source may be improved.

The processor may be configured to upon the radiant flux signal being indicative of that the measured radiant flux is below predetermined radiant flux threshold generate a UV light source failure signal. When the control circuit is placed within a device for purifying potable water, UV light source failure signal may reduce the risk of contaminated water passing through the device. By generating the UV light source failure signal, the UV light source may be replaced so that contaminated water does not reach the end consumer. This may be beneficial if the control circuit is placed to control a device for purifying water that is delivered as potable water to the end consumer.

According to a second aspect, there is provided a device for purifying a fluid, the device comprising: a purifying chamber having a fluid inlet and a fluid outlet for allowing a flow of fluid to be purified to flow there through; a UV light source configured to emit UV light into the purifying chamber; and a control circuit according to the first aspect configured to control the UV light source.

The UV light source of the device may comprise one or more UV LEDs. The one or more UV LEDs may be WICOP LEDs. WICOP LEDs may reduce the number of LEDs with remained efficiency of the device. The one or more UV LEDs may be UV-C LEDs.

According to a third aspect, there is provided a method for controlling a UV light source configured to emit UV light into a purifying chamber of a device for purifying a fluid, the method comprising: determining whether a flow of a fluid through the purifying chamber is present; upon determining non-presence of flow of fluid through the purifying chamber deactivate the UV light source; upon determining presence of flow of fluid through the purifying chamber activate the UV light source; and during the UV light source being active: measure a radiant flux being emitted from the UV light source, compare the measured radiant flux with a reference radiant flux, and adjust a drive current of the UV light source based on the comparison.

The step of determining whether a flow of a fluid through the purifying chamber is present may comprise measuring a flow rate of the fluid flowing through the purifying chamber. The method may comprise adjusting the drive current of the UV light source based on the measured flow rate.

The step of measuring a radiant flux being emitted from the UV light source may comprise measuring a UV-C light radiant flux. The reference radiant flux may be a UV-C light reference radiant flux.

The method may comprise measuring a temperature of a LED of the UV light source. The method may comprise upon the measured temperature being above a predetermined threshold generating a LED overheat signal.

The method may comprise upon the measured radiant flux being below predetermined threshold generating a UV light source failure signal.

According to a fourth aspect, there is provided a non-transitory computer readable recording medium comprising program code portions configured to perform the method according to the third aspect when executed on a device having processing capability.

Generally, the different features and advantages of the second, third, and fourth aspect have been discussed in detail in relation to the first aspect. That discussion is equally valid in relation to the second, third and fourth aspect and reference is therefore made to the above discussion. It may be noted that the various preferred embodiments or optional features are equally applicable to the second, third and fourth aspect.

A further scope of applicability of the present invention will become apparent from the detailed description given below. However, it should be understood that the detailed description and specific examples, while indicating preferred embodiments of the invention, are given by way of illustration only, since various changes and modifications within the scope of the invention will become apparent to those skilled in the art from this detailed description.

Hence, it is to be understood that this invention is not limited to the particular component parts of the device described or acts of the methods described as such device and method may vary. It is also to be understood that the terminology used herein is for purpose of describing particular embodiments only, and is not intended to be limiting. It must be noted that, as used in the specification and the appended claim, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings does not exclude other elements or steps.

### Brief Description of the Drawings

The above and other aspects of the present invention will now be described in more detail, with reference to the appended drawings showing embodiments of the invention. The figures should not be considered limiting the invention to the specific embodiment; instead they are used for explaining and understanding the invention.
Figure 1 illustrates a control circuit.
Figure 2 illustrates a device for purifying fluid comprising the control circuit.
Figure 3 illustrates a flowchart for how to control a UV light source.

As illustrated in the figures, the sizes of layers and regions are exaggerated for illustrative purposes and, thus, are provided to illustrate the general structures of embodiments of the present invention. Like reference numerals refer to like elements throughout.

### Description of Embodiments

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled person.

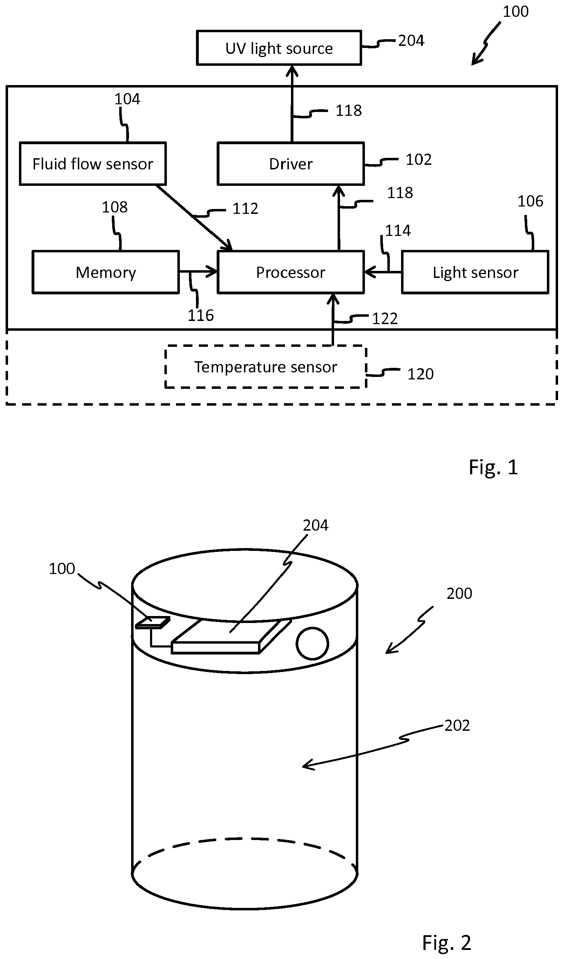

With reference to figures 1 and 2, there is disclosed a control circuit 100 for controlling a UV light source 204 of a device 200 for purifying a fluid. The device comprises a purifying chamber 202, wherein the fluid is purified when the device 200 is in use. The device 200 comprises the UV light source 204. The UV light source 204 is configured to emit UV light into the purifying chamber 202 of the device 200 for purifying a fluid. The device 200 uses UV light to decontaminate and purify fluid present in the purifying chamber 202 when the device 200 is in use. The device 200 further comprises the control circuit 100 to control the UV light source 204. In other words, the UV light emitted into the purifying chamber 202 is controlled when the device 200 is in use.

The control circuit 100 is configured to carry out overall control of the operations and functions of the UV light source 204 of the device 200. The control circuit 100 comprises a driver 102, a fluid flow sensor 104, a light sensor 106, a memory 108 and a processor 110.

The driver 102 is configured to provide the UV light source 204 with a drive current 118. The drive current 118 determines how much UV light that is emitted into the purifying chamber 202. In other words, the driver current 118 is correlated to the UV light output of the UV light source 204.

The UV light source 204 may comprise one or more UV LEDs. The one or more UV LEDs may be UV-C LEDs. The or more UV LEDs may be WICOP LEDs. WICOP LEDs may reduce the number of LEDs with remained efficiency of the device. WICOP LEDs have a smaller footprint than conventional LEDs. This may reduce a size of the UV light source 204. This may allow to make the device 200 small, allowing the device to be placed in small spaces. WICOP LEDs further require less power than regular LEDs. This may improve energy efficiency of the device. UV-C LEDs may provide the device with a more energy efficient UV light source.

The fluid flow sensor 104 is configured to determine whether a flow of a fluid through the purifying chamber 202 is present. Upon determining a presence or non-presence of fluid flow through the purifying chamber 202, the fluid flow sensor 104 is configured to generate a flow signal 112 indicative thereof. The fluid flow sensor 104 may be configured to measure a flow rate of a fluid flowing through the purifying chamber 202. The flow signal 112 may comprise data pertaining to the measured flow rate in the purifying chamber 202.

The light sensor 106 is configured to measure radiant flux of light emitted from the UV light source 204. The light sensor 106 is further configured to generate a radiant flux signal 114. The radiant flux signal 114 comprises data pertaining to the measured radiant flux. The light sensor 106 may be configured to measure UV-C light radiant flux. Light sensor 106 may be configured to continuously measure the radiant flux. The light sensor 106 may measure an initial radiant flux when the device 200 starts up for the first time. The light sensor 106 may be configured to generate an initial radiant flux signal comprising the value of the initial radiant flux. Data pertaining to the initial radiant flux may be stored in the memory 108 as a reference radiant flux 116. Hence, the memory 108 may comprise the reference radiant flux 116. The reference radiant flux 116 may be a UV-C light reference radiant flux. Alternative to measuring and storing the initial radiant flux measured at the first start-up of the device as the reference radiant flux 116, the reference radiant flux 116 may be stored in the memory 108 at manufacture of the control circuit 100, i.e. the reference radiant flux 116 may be a factory set reference radiant flux. A reference radiant flux 116 stored at manufacture of the control circuit 100 may be replaced with the initial radiant flux. Accordingly, the reference radiant flux 116 is a predetermined reference radiant flux. Upon the UV light source 204 is switched on for the first time, the at that time measured radiant flux may be set as the reference radiant flux 116. Alternatively, the reference radiant flux 116 may be a factory set reference radiant flux.

The memory 108 may be one or more of a buffer, a volatile memory, a non-volatile memory, a random access memory (RAM) or another suitable device. In a typical arrangement, the memory 108 may include a non-volatile memory for long term data storage and a volatile memory that functions as system memory for the control circuit 100. The memory 108 may exchange data within the processor 110, and possibly also the fluid flow sensor 104 and the light sensor 106, over a data bus.

The processor 110 may be a central processing unit (CPU), a microcontroller or a microprocessor. The processor 110 is configured to execute program code stored in the memory 108, in order to carry out operations and functions of the control circuit 100. The operations and functions of the control circuit 100 may be embodied in the form of executable logic routines, e.g., lines of code, software programs etc., that are stored on the memory 108 and are executed by the processor 110. Furthermore, the operations and functions of the control circuit 100 may be a stand-alone software application or form a part of a software application that carries out additional tasks related to the control circuit 100. The described operations and functions may be considered a method that the control circuit 100 is configured to carry out. Also, while the described operations and functions will be discussed as implemented in software, such functionality may as well be carried out via dedicated hardware or firmware, or some combination of hardware, firmware and/or software.

The processor 110 is configured to execute a UV light source activation function. The UV light source activation function is configured to deactivate the UV light source 204 upon the flow signal 112 being indicative of non-presence of flow of fluid through the purifying chamber 202. In other words, when there is no flow of fluid in the purifying chamber 202, the UV light source 204 is switched to an off mode. The UV light source activation function is further configured to activate the UV light source upon the flow signal is indicative of presence of flow of fluid through the purifying chamber. In other words, when there is a flow of fluid in the purifying chamber 202, the UV light source 204 is switched to an on mode. Thus, the UV light source 204 does not use any power when there is no fluid to be purified present in the purifying chamber 202. This may improve the life span of the UV light source. This may achieve an efficient and environmentally friendly device for purification of fluid.

The processor 110 is further configured to execute a drive current setting function. The drive current setting function is configured to determine a drive current 118 for the driver 102. Especially, the drive current setting function is configured to, upon the UV light source being active, determine the drive current 118 for the driver 102. The drive current setting function is configured to set the drive current 118 for the driver 102 based on the measured radiant flux being comprised in the radiant flux signal 114 and the reference radiant flux 116 stored in the memory 108. This may be accomplished through comparing the measured radiant flux with the reference radiant flux 116 and thereafter setting the drive current 118 based on said comparison.

The drive current setting function may further be configured to base the setting of the drive current 118 for the driver 108 on the measured flow rate comprised in the flow signal 112. The drive current setting function may compensate a loss of radiant flux by adjusting the drive current 118 such that efficiency of the UV light source is retained.

The processor 112 may further be configured to execute a fail test function. The fail test function is configured to check whether the radiant flux signal being indicative of that the measured radiant flux is below a predetermined radiant flux threshold. If so, the fail test function is configured to generate a UV light source failure signal. The predetermined radiant flux threshold may be factory set threshold. The predetermined radiant flux threshold may be indicative of how much UV-light that is needed to effectively purify and decontaminate the fluid. The predetermined radiant flux threshold may have different values depending on which type of fluid is to be purified in the purifying chamber 202. For example, the fail test function may be configured to generate the UV light source failure signal when the measured radiant flux is below 70% of the reference radiant flux.

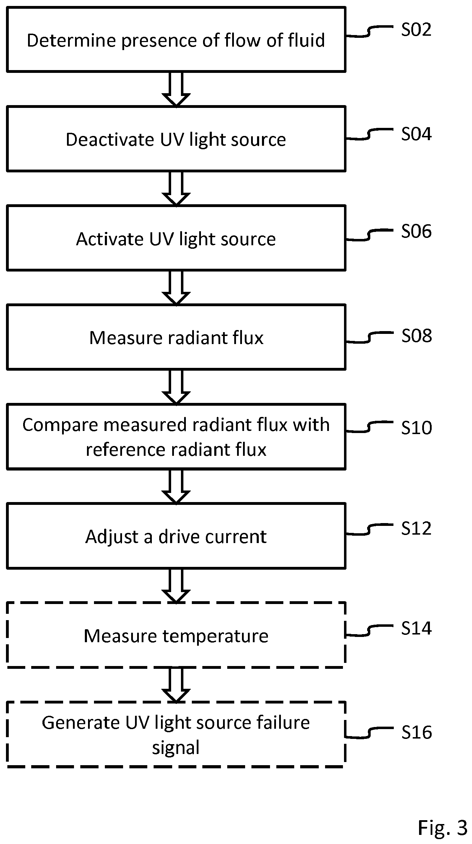

In connection with Fig. 3, a method for controlling a UV light source (204) will be discussed. Especially, for controlling a UV light source (204) configured to emit UV light into a purifying chamber (202) of a device (200) for purifying a fluid. The steps of the method may be performed in any order suitable. The method comprises the following steps.

Determining S02 whether a flow of a fluid through the purifying chamber is present. Upon determining non-presence of flow of fluid through the purifying chamber deactivate S04 the UV light source. Upon determining presence of flow of fluid through the purifying chamber activate S06 the UV light source. During the UV light source being active: measure S08 a radiant flux being emitted from the UV light source 204, compare S10 the measured radiant flux with a reference radiant flux 116, and adjust S12 a drive current of the UV light source based on the comparison.

The step of determining S02 whether a flow of a fluid through the purifying chamber 202 is present may comprise measuring a flow rate of the fluid flowing through the purifying chamber. The step of adjusting S12 the drive current of the UV light source may further be based on the measured flow rate.

The step of measuring S08 a radiant flux being emitted from the UV light source may comprise measuring a UV-C light radiant flux. The reference radiant flux may be a UV-C light reference radiant flux.

The method may further comprise measuring S14 a temperature of a LED of the UV light source. Upon the measured temperature being above a predetermined threshold a LED overheat signal may be generated.

The method may further comprise upon the measured radiant flux being below a predetermined threshold, generate S16 a UV light source failure signal.

The person skilled in the art realizes that the present invention by no means is limited to the preferred embodiments described above. On the contrary, many modifications and variations are possible within the scope of the appended claims.

For example, the control unit 100 may further comprise a temperature sensor 120. The temperature sensor 120 may be configured to measure a temperature of the UV light source 204. The temperature sensor 120 may be configured to measure a temperature of an individual UV LED of the UV light source 204. The temperature sensor 120 may be configured to generate a temperature signal 122. For example, the temperature sensor 120 may be configured to measure a temperature at a P-N junction of the individual UV LED. The temperature signal 122 may comprise a temperature of a surrounding of the individual UV LED. The temperature signal 122 may comprise a temperature of the individual UV LED. The processor 110 may be configured to execute an overheat checking function. The overheat checking function is configured to use the temperature signal from the temperature sensor 120 as input. For example, the overheat checking function may be configured to, upon the temperature signal being indicative of that the temperature of an individual UV LED is above a predetermined temperature threshold generate a LED overheat signal. The overheat checking function may be configured to deactivate the individual LED upon the temperature signal being indicative of that the temperature of the individual LED is above the predetermined temperature threshold. The predetermined temperature threshold may be a factory set threshold.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A control circuit (100) for controlling a UV light source (204) configured to emit UV light into a purifying chamber (202) of a device (200) for purifying a fluid, the control circuit (100) comprising:
a driver (102) configured to provide the UV light source (204) with a drive current (118);
a fluid flow sensor (104) configured to determine whether a flow of a fluid through the purifying chamber (202) is present and generate a flow signal (112) indicative thereof;
a light sensor (106) configured to measure radiant flux of light emitted from the UV light source (204) and to generate a radiant flux signal (114) comprising data pertaining to the measured radiant flux;
a memory (108) comprising a reference radiant flux (116); and
a processor (110) configured to:
deactivate the UV light source (204) upon the flow signal (112) being indicative of non-presence of flow of fluid through the purifying chamber (202),
activate the UV light source (204) upon the flow signal (112) being indicative of presence of flow of fluid through the purifying chamber (202),
during the UV light source (204) being active:
determine the drive current (118) for the driver (102) based on the measured radiant flux comprised in the radiant flux signal (114) and the reference radiant flux (116).

2. The control circuit (100) according to claim 1, wherein the fluid flow sensor (104) is further configured to measure a flow rate of a fluid flowing through the purifying chamber (202), wherein the flow signal (112) comprises data pertaining to the measured flow rate, and wherein the processor (110) is further configured to determine the drive current (118) for the driver based on the measured flow rate comprised in the flow signal (112).

3. The control circuit (100) according to claim 1 or 2, wherein the light sensor (106) is configured to measure UV-C light radiant flux and wherein the reference radiant flux (116) is a UV-C light reference radiant flux.

4. The control circuit (100) according to any one of claims 1-3, wherein the UV light source (204) comprises one or more UV LEDs.

5. The control circuit (100) according to claim 4, further comprising a temperature sensor (120) configured to measure a temperature of a UV LED and generate a temperature signal (122), wherein the processor (110) is configured to upon the temperature signal (122) being indicative of that the temperature of the LED is above a predetermined temperature threshold generate a LED overheat signal.

6. The control circuit (100) according to any one of claims 1-5, wherein the processor (110) is configured to upon the radiant flux signal (114) being indicative of that the measured radiant flux is below a predetermined radiant flux threshold generate a UV light source failure signal.

7. The control circuit (100) according to claim 6, wherein the predetermined radiant flux threshold is a factory set threshold.

8. A device (2009 for purifying a fluid, the device (200) comprising:
a purifying chamber (202) having a fluid inlet and a fluid outlet for allowing a flow of fluid to be purified to flow there through;
a UV light source (204) configured to emit UV light into the purifying chamber (202); and
a control circuit (100) according to any one of claims 1-7, configured to control the UV light source (204).

9. The device (200) according to claim 8, wherein the UV light source (204) comprises one or more UV LEDs, wherein the one or more UV LEDs are WICOP LEDs.

10. A method for controlling a UV light source (204) configured to emit UV light into a purifying chamber (202) of a device (200) for purifying a fluid, the method comprising:
determining (S02) whether a flow of a fluid through the purifying chamber (202) is present;
upon determining non-presence of flow of fluid through the purifying chamber (202) deactivate (S04) the UV light source (204);
upon determining presence of flow of fluid through the purifying chamber (202) activate (S06) the UV light source (204); and
during the UV light source (204) being active:
measure (S08) a radiant flux being emitted from the UV light source (204),
compare (S10) the measured radiant flux with a reference radiant flux (116), and
adjust (S12) a drive current (118) of the UV light source (204) based on the comparison.

11. The method according to claim 10, wherein the step of determining (S02) whether a flow of a fluid through the purifying chamber (202) is present comprises measuring a flow rate of the fluid flowing through the purifying chamber, wherein the method further comprises adjusting the drive current of the UV light source based on the measured flow rate.

12. The method according to claim 10 or 11, wherein the step of measuring (S08) a radiant flux being emitted from the UV light source (204) comprises measuring a UV-C light radiant flux and wherein the reference radiant flux (116) is a UV-C light reference radiant flux.

13. The method according to any one of claims 10-12, further comprising measuring (S14) a temperature of a LED of the UV light source (204), upon the measured temperature being above a predetermined threshold generate a LED overheat signal.

14. The method according to any one of claims 10-13, further comprising upon the measured radiant flux being below a predetermined threshold generate (S16) a UV light source failure signal.

15. A non-transitory computer readable recording medium comprising program code portions configured to perform the method according to any one of claims 10-14 when executed on a device having processing capability.
